# EUROPÄISCHE PATENTSCHRIFT

(11) **EP 3 652 471 B1**
(45) Veröffentlichungstag und Bekanntmachung des Hinweises auf die Patenterteilung: **09.06.2021**
(21) Anmeldenummer: 17737789.2
(22) Anmeldetag: 11.07.2017
(51) Int. Cl.: F16K 1/00, B81C 1/00, F16K 99/00

(54) **MIKRORÜCKSCHLAGVENTIL SOWIE SYSTEM MIT MEHREREN MIKRORÜCKSCHLAGVENTILEN UND VERFAHREN ZU DESSEN HERSTELLUNG**
MICRO CHECK VALVE AND SYSTEM WITH MULTIPLE MICRO CHECK VALVES AND METHOD FOR THE PRODUCTION THEREOF
MICRO-CLAPET ANTI-RETOUR ET SYSTÈME COMPRENANT PLUSIEURS MICRO-CLAPETS ANTI-RETOUR ET PROCÉDÉ POUR LA FABRICATION DE CES DERNIERS

(43) Veröffentlichungstag der Anmeldung: 20.05.2020
(73) Patentinhaber: Microfab Service GmbH, 28359 Bremen (DE)
(72) Erfinder: CORDELAIR, Marco, 27412 Tarmstedt (DE)
(74) Vertreter: Eisenführ Speiser
(86) Internationale Anmeldenummer: PCT/EP2017/067316
(87) Internationale Veröffentlichungsnummer: WO 2019/011410

(56) Entgegenhaltungen:
- WO-A1-97/05385
- GB-A- 2 155 152
- GB-A- 2 443 260
- US-A- 5 325 880
- US-A1- 2007 026 269
- US-A1- 2014 264 650
- US-A1- 2015 001 653
- US-B1- 6 334 761

## Beschreibung

Die Erfindung betrifft ein Mikrorückschlagventil sowie ein System mit mehreren Mikrorückschlagventilen und ein Verfahren zu deren Herstellung.

Aus dem Stand der Technik sind Rückschlagventile, die auch Rückschlagarmaturen genannt werden, bekannt. Rückschlagventile ermöglichen den Fluidfluss durch das Rückschlagventil in einer vordefinierten Richtung, während der Rückfluss, also der Fluss in die entgegengesetzte Richtung, durch einen Sperrmechanismus verhindert oder zumindest die Flussmenge reduziert wird.

Im Bereich der Mikrosystemtechnik sind Rückschlagventile bekannt, die durch hybride Fertigung unter Verwendung eines Substrats gefertigt werden. Beispielsweise sind aus DE 697 22 798 T2 Mikroventile bekannt, die ein Substrat mit einem Kanal durch das Substrat aufweisen. An einem Ende des Kanals ist eine dünne Schicht einer gewalzten Metallfolie durch Anodenverschweißung mit dem Substrat verbunden. Diese Metallfolie weist mehrere Öffnungen auf, die radial außerhalb des Kanals liegen.

So kann ein Fluid, das durch den Kanal in Richtung auf die Folie fließt, durch die Öffnungen in der Metallfolie hinausfließen. Ein Rückfluss ist nicht möglich, da eine Druckdifferenz in umgekehrter Richtung, also ein erhöhter Druck oberhalb der Metallfolie außerhalb des Kanals im Vergleich zum Druck im Kanal, dafür sorgt, dass die Metallfolie gegen die Kanalöffnung drückt und diesen so verschließt.

Derartige Mikrorückschlagventile sind beispielsweise für die medizinische Verwendung bekannt, um beispielsweise kontrollierte Mengen Arzneimittel aus einem Reservoir in einen Anwendungsbereich zu führen, wobei durch die Sperrwirkung verhindert wird, dass Fremdfluide aus dem Anwendungsbereich in das Reservoir des Arzneimittels eindringen. Ein Beispiel für diese Ventile ist Dokument GB 2 443 260 A zu entnehmen, bei dem eine Membran an einem oder zwei Körpern durch Klammern, Kleben, Bonden oder Schweißen verbunden wird. WO97/05385 A1 (Abbildung 6) offenbart ein Mikrorückschlagventil nach dem Stand der Technik. Die US6334761 B1 offenbart ein Verfahren zur Herstellung eines Mikrorückschlagventils.

Die oben genannte Anodenverschweißung oder anodische Schweißtechnik, mit der die Metallfolie am Substrat befestigt wird, erfolgt bei Temperaturen im Bereich von wenigen hundert Grad Celsius. Entsprechende durch dieses Verfahren hergestellte Verbindungen können sich somit auch bei derartigen Temperaturen wieder lösen. Daher sind die bekannten Mikrorückschlagventile nicht für Hochtemperaturanwendungen geeignet.

Es gibt darüber hinaus Ansätze, Rückschlagventile durch monolithische Integration als Mikrosystem herzustellen, wobei die bisherigen Lösungen, die frei bewegliche Strukturen umfassen, für sicherheitsrelevante Anwendungen, beispielsweise auch im medizinischen Bereich, insbesondere aufgrund ihrer teilweise unzureichenden Schließwirkung, nicht geeignet sind. Ein Beispiel für ein weiteres Rückschlagventil ist dem Dokument US 6,334,761 B1 zu entnehmen, bei dem eine Parylen-Schicht als Membran auf einem Substrat abgeschieden wird.

Aufgabe der vorliegenden Erfindung ist es daher, ein Mikrorückschlagventil sowie ein System damit und ein Verfahren zu dessen Herstellung zu finden, das den Nachteilen des Standes der Technik begegnet. Insbesondere soll ein zuverlässiges Mikrorückschlagventil gefunden werden, das vorzugsweise auch im Bereich von Hochtemperaturanwendungen einsetzbar ist.

Die Erfindung betrifft hierzu ein Mikrorückschlagventil mit einem Substratkörper, der eine Oberseite und eine Unterseite aufweist. Zumindest die Oberseite weist eine erste Wanne und eine zweite Wanne auf. Zwischen der ersten Wanne und der zweiten Wanne ist ein Dichtungssteg angeordnet. Die Wannen entsprechen jeweils vorzugsweise einer Vertiefung im Substrat. Der Dichtungssteg kann auch als Steg mit einer Dichtfläche oder Dichtung bezeichnet werden und trennt die durch die beiden Wannen umfassten Innenräume voneinander. Je nach Abstand der Wannen voneinander weist der Dichtungssteg somit eine entsprechende Breite auf.

Außerdem weist der Substratkörper mindestens einen Kanal auf, der von der Oberseite des Substratkörpers zur Unterseite des Substratkörpers führt und einen Durchbruch zwischen der Oberseite und der Unterseite des Substratkörpers darstellt. Der mindestens eine Kanal endet auf der Oberseite in der ersten Wanne oder mündet in diese. Im Falle mehrerer Kanäle enden alle Kanäle in der ersten Wanne.

Außerdem umfasst der Substratkörper auf seiner Oberseite eine Membran, die vorzugsweise aus einer Nitridschicht besteht. Die Membran ist vorzugsweise durch eine abgeschiedene Schicht gebildet, die also durch einen Abscheidungsprozess, insbesondere einen LPCVD-, PECVD-, Sputter- oder Aufdampfprozess, erzeugt wird.

Die Membran ist teilweise frei beweglich und/oder flexibel. So ist die Membran derart mit dem Substratkörper direkt oder indirekt verbunden, dass diese zumindest im Bereich oberhalb der ersten Wanne, des Dichtungsstegs und der zweiten Wanne in Richtung eines Normalenvektors zur Oberfläche des Substratkörpers gegenüber dem Substratkörper beweglich ist. Die Membran ist also mit der Oberfläche des Substratkörpers nur teilweise direkt oder indirekt starr verbunden, sodass diese zum Ermöglichen der Beweglichkeit im Bereich der Wannen und des Dichtungsstegs unverbunden, also nicht verbunden, ist. Die Membran bildet somit im Bereich des Dichtungsstegs zusammen mit dem Dichtungssteg eine Art Ventil, um je nach Position der Membran einen Fluidfluss oder Aerosolfluss von der ersten in die zweite Wanne oder umgekehrt zu ermöglichen oder zu verhindern bzw. zu minimieren.

Die Membran weist außerdem mindestens einen Durchbruch auf, der oberhalb der zweiten Wanne angeordnet ist. Der Durchbruch ist also oberhalb der zweiten Wanne, also in dem Bereich der Membran, der oberhalb der zweiten Wanne liegt, angeordnet.

Demnach wird ein Mikrorückschlagventil vorgeschlagen, das keine frei beweglichen Elemente aufweist und zum Schalten und Sperren auf eine flexible Membran zurückgreift, die in einem Außenbereich eines aktiven Teils des Mikrorückschlagventils mit dem Substrat teilweise durch einen Abscheidungsprozess verbunden ist und somit nur vordefinierte Freiheitsgrade bei der Bewegung aufweist. Außerdem ist das Mikrorückschlagventil durch die abgeschiedene Membran durch monolithische Integration hergestellt. Somit ist das Mikrorückschlagventil in Hochtemperaturanwendungen, beispielsweise bei Anwendungen im Bereich über 350° C, anwendbar. Wird die Membran vorzugsweise durch einen LPCVD- oder PECVD-Prozess abgeschieden, sind auch Anwendungen im Temperaturbereich von über 500° C möglich.

Gemäß einer ersten Ausführungsform ist die erste Wanne als erste Vertiefung im Substratkörper ausgebildet und vorzugsweise durch den Dichtungssteg begrenzt. Die erste Vertiefung ist vorzugsweise rund, insbesondere kreisförmig, ausgestaltet. Die zweite Wanne ist als zweite, die erste Vertiefung umlaufende, Vertiefung im Substratkörper ausgebildet, die vorzugsweise ringförmig, insbesondere kreisringförmig, ausgebildet ist. Hierbei ist die erste Wanne umlaufend durch den Dichtungssteg von der zweiten Wanne getrennt, wobei der Dichtungssteg vorzugsweise ringförmig, insbesondere kreisringförmig, ist.

Demnach weisen also die erste Vertiefung und die zweite Vertiefung vorzugsweise Mittelpunkte auf, die im Wesentlichen an der gleichen Position liegen. Die zweite Vertiefung weist vorzugsweise einen Innenkreisdurchmesser auf und die erste Vertiefung einen Außenkreisdurchmesser, der kleiner als der Innenkreisdurchmesser der zweiten Vertiefung ist, sodass sich ein ringförmiger Steg zwischen der ringförmigen Vertiefung und der runden Vertiefung bildet, der dem Dichtungssteg entspricht und auch als Dichtung oder Dichtring bezeichnet werden kann.

Gemäß einer weiteren Ausführungsform definiert die erste Wanne mit der Membran eine innere Kammer und die zweite Wanne mit der Membran eine äußere Kammer. Außerdem bildet der Dichtungssteg ein Ventil mit der Membran, die eingerichtet ist, einen Fluidfluss und/oder Aerosolfluss zwischen der inneren Kammer und der äußeren Kammer im Wesentlichen zu verhindern oder zu reduzieren.

Eine Flüssigkeit oder ein Aerosol kann somit durch den mindestens einen Kanal in die innere Kammer strömen und im Falle, dass die Membran gegen den Dichtungssteg, also den Steg zwischen den Wannen, gedrückt ist, am Weiterströmen gehindert werden. Wird hingegen die Membran in Richtung der Normalen zur Substratkörperoberfläche bewegt, so liegt diese nicht mehr an dem Dichtungssteg an und die Flüssigkeit oder das Aerosol kann in die zweite Kammer strömen. Durch den oder die Durchbrüche in der Membran oberhalb der zweiten Wanne, also in der zweiten Kammer, kann die Flüssigkeit oder das Aerosol dann in die Peripherie des Mikrorückschlagventils strömen.

Ein Durchbruch entspricht demnach einem Verbindungskanal zwischen der Peripherie des Mikrorückschlagventils, also der äußeren Umgebung, und der zweiten Kammer, die durch die zweite Vertiefung und die Membran im Wesentlichen umschlossen wird.

Gemäß einer weiteren Ausführungsform weist das Mikrorückschlagventil einen geöffneten und einen geschlossenen Zustand auf. Das Mikrorückschlagventil ist außerdem ausgebildet, den geöffneten Zustand einzunehmen, wenn eine Druckdifferenz eines Fluides oder Aerosols zwischen einem Druck im mindestens einen Kanal und einem Druck oberhalb der Membran auf oder über einer vordefinierten Mindestdruckdifferenz liegt. Außerdem ist das Mikrorückschlagventil eingerichtet, den geschlossenen Zustand einzunehmen, wenn die Druckdifferenz unterhalb der Mindestdruckdifferenz liegt.

Oberhalb der Membran bezeichnet hier die Peripherie, also den Bereich der Umgebung auf der Oberseite der Membran, also der Seite der Membran, die nicht zum Substratkörper gerichtet ist.

Demnach öffnet das Mikrorückschlagventil also, wenn durch den mindestens einen Kanal ein Fluid, nämlich beispielsweise eine Flüssigkeit oder ein Gas, oder ein Aerosol in die erste Wanne bzw. erste Kammer eingebracht wird und hier gegen die Membran drückt. Somit nimmt der Abstand zwischen dem Dichtungssteg bzw. dem Steg zu, sodass das Fluid oder Aerosol in die zweite Wanne bzw. zweite Kammer fließen und aus den Durchbrüchen heraustreten kann. Das durch den Dichtungssteg und die Membran definierte Ventil öffnet somit.

Einen geschlossenen Zustand nimmt das Mikrorückschlagventil in dem Fall ein, dass der Druck eines Fluides oder Aerosols von oberhalb auf die Membran drückt, sodass diese gegen den Dichtungssteg bzw. Steg gedrückt wird und dieser somit den Durchgang zwischen der ersten und zweiten Wanne bzw. Kammer sperrt. Durch die Öffnungen kann im geschlossenen Zustand ein Fluid oder Aerosol zwar in die zweite Wanne eintreten, gelangt jedoch nicht weiter in die erste Kammer und den mindestens einen Kanal. Das durch den Dichtungssteg und die Membran definierte Ventil schließt somit.

Wirkt keine Druckdifferenz auf die Membran, befindet sich das Mikrorückschlagventil entsprechend in einer durch eine Vorspannung der Membran definierten Stellung, die vorzugsweise dem geschlossenen Zustand entspricht. Zwar kann ein geringer Abstand zwischen dem Dichtungssteg bzw. dem Steg und der Membran vorgesehen sein, um Klebeeffekte zu verhindern, wobei bei Anwesenheit von Flüssigkeit durch Van-der-Waals-Kräfte die Membran an den Substratkörper herangezogen wird und dadurch jedenfalls ein geschlossener Zustand erreicht wird. Bei Gasen würde in diesem Fall, also auch im geschlossenen Zustand, eine geringe Menge an Gas durch das Mikrorückschlagventil entweichen.

Gemäß einer weiteren Ausführungsform weist der Dichtungssteg an seiner Oberseite eine Ebene auf, die tiefer im Substratkörper liegt als die Ebene des Substratkörpers im Bereich außerhalb der zweiten Wanne, die auf der Oberseite des Substratkörpers gebildet ist. Der zuletzt genannte Bereich außerhalb der zweiten Wanne entspricht dem Bereich, der außerhalb eines Außendurchmessers der zweiten Wanne liegt und somit einem äußeren Wannenrand entspricht.

Hierdurch wird ein geringer Abstand, der auch als Spalt oder Gap bezeichnet werden kann, vorzugsweise von wenigen Mikrometern, zwischen dem Substratkörper im Bereich zwischen Dichtungssteg sowie der Membran, insbesondere der Dichtfläche des Stegs und der Membran, erzeugt, sodass Klebeeffekte zwischen der Membran und dem Dichtungssteg, die dazu führen können, dass das Rückschlagventil nicht öffnet, reduziert werden. Ein zuverlässiges Öffnen und Schließen des Mikrorückschlagventils ist somit möglich.

Gemäß einer weiteren Ausführungsform weist die Membran mehrere Durchbrüche auf, die oberhalb der zweiten Wanne, also im Bereich der Membran, die oberhalb der zweiten Wanne liegt, angeordnet sind. Diese Durchbrüche sind derart verteilt angeordnet, um definierte Sprührichtungen oder eine vordefinierte Vorzugssprührichtung eines durch die Durchbrüche geführten Fluides oder Aerosols zu erzeugen. Eine Vorzugssprührichtung ist hier die Sprührichtung, in die die in Summe größte Menge eines Fluides oder Aerosols befördert wird oder die sich durch Summation der Richtungsvektoren der einzelnen Sprührichtungen ergibt.

Somit kann das Mikrorückschlagventil gleichzeitig als Sprühkopf verwendet werden, wobei durch Wählen der Vorzugssprührichtung die Orientierung beim Einbau des Mikrorückschlagventils in ein System berücksichtigbar ist. Das Mikrorückschlagventil ist somit als integriertes System mit Rückschlagventilfunktion sowie Sprühkopffunktion einsetzbar.

Gemäß einer weiteren Ausführungsform ist mindestens einer oder sind alle Durchbrüche rund und/oder ist mindestens einer oder sind alle Durchbrüche oval und/oder ist mindestens einer oder sind alle Durchbrüche trapezförmig, eckig, dreieckig, mehreckig mit abgerundeten Ecken.

Hierdurch lassen sich eine oder mehrere vordefinierte Sprührichtungen oder eine Vorzugssprührichtung im Falle eines geöffneten Mikrorückschlagventils und eines durch das Rückschlagventil geführten Fluides oder Aerosols einstellen, wobei sich die Sprührichtung auch durch mehrere gleiche oder mehrere unterschiedliche Formen der Durchbrüche erzeugen lässt. Gleichzeitig weisen die Durchbrüche durch die genannten Formen keine Ecken auf, an denen Spannungen und damit Risse auftreten könnten. Eine Langlebigkeit des Mikrorückschlagventils wird somit begünstigt.

Gemäß einer weiteren Ausführungsform umfasst das Mikrorückschlagventil mindestens einen Federarm, der ein erstes Ende und ein zweites Ende aufweist. Das erste Ende ist direkt oder indirekt mit der Membran in dem Bereich, in dem die Membran beweglich ist, verbunden und das zweite Ende ist mit dem Substratkörper direkt oder indirekt verbunden.

Ist das zweite Ende indirekt mit dem Substratkörper, beispielsweise über einen Teil der Membran, verbunden, so ist das zweite Ende mit dem Substratkörper in dem Bereich über die Membran mit dem Substratkörper verbunden, der nicht beweglich ist, also starr mit dem Substratkörper verbunden ist. Durch den oder die Federarme lässt sich die Membran in eine vordefinierte Ruhelage in Abhängigkeit einer Vorspannung des oder der Federarme bringen, wobei hierdurch auch die Mindestdruckdifferenz zum Umschalten des Mikrorückschlagventils kontrollierbar bzw. anpassbar ist.

Der oder die Federarme bestehen hierzu aus einem Material, das eine Vorspannung aufweist, um eine vordefinierte Federkraft auszuüben. Beispielsweise ist der Federarm durch einen Prozess abgeschieden, sodass eine Spannung im Material auftritt, die so kontrolliert erzeugt wird, dass hierdurch die Vorspannung erzeugt wird. Vorteilhafterweise besteht der oder die Federarme dazu aus oxidiertem Polysilizium.

Gemäß einer weiteren Ausführungsform umfasst die Membran zumindest in Teilen des beweglichen Bereichs der Membran, der oberhalb der Wannen und des Dichtungsstegs liegt, eine Versteifungsstruktur, die zum Beispiel eine Platte, ein Ring oder ein Gitter ist. Das Versteifungselement ist aus einer zusätzlich zur Membran abgeschiedenen Schicht gebildet. Vorzugsweise wird das Versteifungselement in einem Abscheidungsprozess zusammen mit dem oder den Federarmen abgeschieden. Über das Versteifungselement ist das erste Ende des mindestens einen Federarms indirekt mit der Membran verbunden.

Dank des Versteifungselements ist eine gleichmäßigere Kraftverteilung, insbesondere mehrerer Federarme, auf die Membran möglich, sodass keine punktuelle Belastung auf die Membran erzeugt wird und die Membran durch das Ausüben der Kraft durch den Federarm sowie einer Gegenkraft durch einen Fluiddruck oder einen Aerosoldruck, der auf die Membran ausgeübt wird, nicht zerstört wird.

Das Versteifungselement sowie der oder die Federarme werden vorteilhafterweise in einem gemeinsamen Schritt durch einen Abscheidungsprozess, vorzugsweise aus Polysilizium, abgeschieden und danach oxidiert. Durch die Oxidation lässt sich eine Spannung im Polysilizium erzeugen, mit der sich die Federkraft des oder der Federarme einstellen lässt.

Gemäß einer weiteren Ausführungsform ist der mindestens eine Federarm ausgebildet, eine Kraft auf den beweglichen Bereich der Membran auszuüben, die in Richtung auf den Substratkörper wirkt. Somit wird das Mikrorückschlagventil immer sicher geschlossen gehalten, auch wenn kein Druck durch ein Fluid oder ein Aerosol auf die Membran wirkt.

Gemäß einer weiteren Ausführungsform ist die Dicke der Membran und/oder die Federkraft des mindestens einen Federarms und/oder die Größe der Oberfläche und/oder Anzahl der Durchbrüche in der Membran derart gewählt, um eine vordefinierte Minimaldruckdifferenz, also einen vordefinierten Öffnungsdruck und/oder einen vordefinierten Schließdruck, sowie eine vordefinierte Durchflussmenge bereitzustellen. Ein Öffnungsdruck und/oder Schließdruck kann durch eine Anwendung vordefiniert sein und wird vorzugsweise durch die oben genannte Minimaldruckdifferenz beschrieben.

Durch Variation der Dicke der Membran, der Federkraft der Federarme und/oder der Fläche des mindestens einen Durchbruchs ist somit auf einfache Weise ein gewünschter Schließ- und/oder Öffnungsdruck definierbar.

Außerdem umfasst die Erfindung ein System mit mehreren Mikrorückschlagventilen nach einer der vorgenannten Ausführungsformen. Die Mikrorückschlagventile weisen hierbei einen gemeinsamen Substratkörper auf. Demnach ist auch das System als monolithisches System zu bezeichnen.

Gemäß einer Ausführungsform des Systems sind die Durchbrüche in den Membranen der mehreren Mikrorückschlagventile des Systems derart verteilt angeordnet, um eine vordefinierte Vorzugssprührichtung eines durch die Durchbrüche geführten Fluides oder Aerosols zu erzeugen.

Außerdem umfasst die Erfindung ein Verfahren zum Herstellen eines Mikrorückschlagventils, insbesondere nach einer der vorgenannten Ausführungsformen, insbesondere für ein System gemäß einer der vorgenannten Ausführungsformen.

Zur Herstellung werden zunächst eine erste Oxidschicht, die insbesondere rund ist, und eine zweite Oxidschicht, die insbesondere ringförmig ist, auf der Oberseite eines Substratkörpers, der eine Oberseite und eine Unterseite aufweist, erzeugt. In einem weiteren Schritt wird eine Schicht auf der Oberseite des Substratkörpers zum Bilden einer Membran zumindest oberhalb der ersten Oxidschicht und der zweiten Oxidschicht abgeschieden. Im nächsten Schritt werden Durchbrüche in die Membran im Bereich oberhalb der zweiten Oxidschicht geätzt und im darauffolgenden Schritt mindestens ein Kanal von der Unterseite des Substratkörpers bis zur ersten Oxidschicht geätzt. Die beiden letztgenannten Schritte können auch in umgekehrter Reihenfolge ausgeführt werden. Zuletzt werden die Oxidschichten entfernt.

Durch besonders wenige Schritte ist somit ein Mikrorückschlagventil kostengünstig und in einfacher Weise herstellbar. Die erste Oxidschicht wird nach dem Entfernen des Oxids zu einer ersten Wanne und entsprechend wird die zweite Oxidschicht nach dem Entfernen des Oxids zu einer zweiten Wanne.

Gemäß einer Ausführungsform des Verfahrens wird nach dem Erzeugen der ersten und zweiten Oxidschicht und vor dem Abscheiden der Membran eine dritte Oxidschicht in dem Bereich zwischen der ersten Oxidschicht und der zweiten Oxidschicht erzeugt. Hierdurch wird der bereits oben genannte Spalt bzw. das Gap auf einfache Weise erzeugt. Alternativ kann in diesem Schritt auch eine Oxidschicht über der ersten Oxidschicht, der zweiten Oxidschicht sowie im dazwischenliegenden Bereich durch Abscheidung aufgebaut werden. Hierdurch wird der Schritt des Entfernens der Oxidschichten beschleunigt.

Gemäß einer Ausführungsform des Verfahrens wird die dritte Oxidschicht zum Erzeugen eines Dichtungsstegs zwischen der ersten und zweiten Wanne, insbesondere für eine Dichtung, mit einer Dicke hergestellt, die geringer ist als die Dicke der ersten und/oder zweiten Oxidschicht. Hierdurch wird später eine Ebene auf dem Dichtungssteg erzeugt, die tiefer liegt als die Ebene des Substratkörpers außerhalb der zweiten Wanne.

Gemäß einer weiteren Ausführungsform des Verfahrens wird die Membran mit einer Schichtdicke abgeschieden, die von einer vorbestimmten Mindestdruckdifferenz, die auch Minimaldruckdifferenz genannt werden kann, für das Öffnen und Schließen des Mikrorückschlagventils abhängig ist. Durch Einstellen der Schichtdicke lässt sich somit direkt die Mindestdruckdifferenz für das Schalten des Mikrorückschlagventils definieren.

Gemäß einer weiteren Ausführungsform des Verfahrens wird nach Abschluss der zuvor genannten Schritte eine Oxidation der erzeugten Struktur durchgeführt. Hierdurch können einerseits die offenen Strukturen, insbesondere zwischen Membran und Dichtungssteg, verkleinert werden, um eine verbesserte Dichtigkeit des Rückschlagventils in Sperrrichtung zu erzeugen. Gleichzeitig wird eine definierte Oxidschichtoberfläche geschaffen, die besonders stabil bei sich verändernden äußeren Einflüssen, wie Temperatur und Feuchtigkeit, und daher geeignet für medizinische Anwendungen ist.

Weitere Ausführungsformen ergeben sich anhand der in den Figuren näher erläuterten Ausführungsbeispiele.
- Fig. 1: zeigt ein Mikrorückschlagventil gemäß einem ersten Ausführungsbeispiel im Schnitt,
- Fig. 2: eine Vergrößerung eines Ausschnitts aus Fig. 1,
- Fig. 3: eine Draufsicht auf das Mikrorückschlagventil aus Fig. 1 und 2,
- Fig. 4: eine perspektivische Schnittansicht des Mikrorückschlagventils der Fig. 1 bis 3,
- Fig. 5a bis 5c: die Oberseite unterschiedlicher Mikrorückschlagventile mit unterschiedlichen Ausbildungen der Durchbrüche,
- Fig. 6: ein weiteres Ausführungsbeispiel eines Rückschlagventils,
- Fig. 7: die Schritte zum Herstellen eines Mikrorückschlagventils gemäß einem Ausführungsbeispiel,
- Fig. 8: einen zusätzlichen Schritt zu den in Fig. 7 gezeigten Schritten zum Herstellen eines Mikrorückschlagventils gemäß einem weiteren Ausführungsbeispiel,
- Fig. 9: eine Draufsicht auf ein Mikrorückschlagventil, das mit den Schritten, die in Fig. 7 dargestellt sind, hergestellt ist,
- Fig. 10: ein weiteres Ausführungsbeispiel zum Herstellen eines Mikrorückschlagventils,
- Fig. 11: die Schritte zum Herstellen von Federarmen und eines Versteifungselements eines Mikrorückschlagventils und
- Fig. 12: eine Draufsicht auf ein Mikrorückschlagventil mit Federarmen und einem Versteifungselement, das mit den Schritten, die in Fig. 11 dargestellt sind, hergestellt ist.

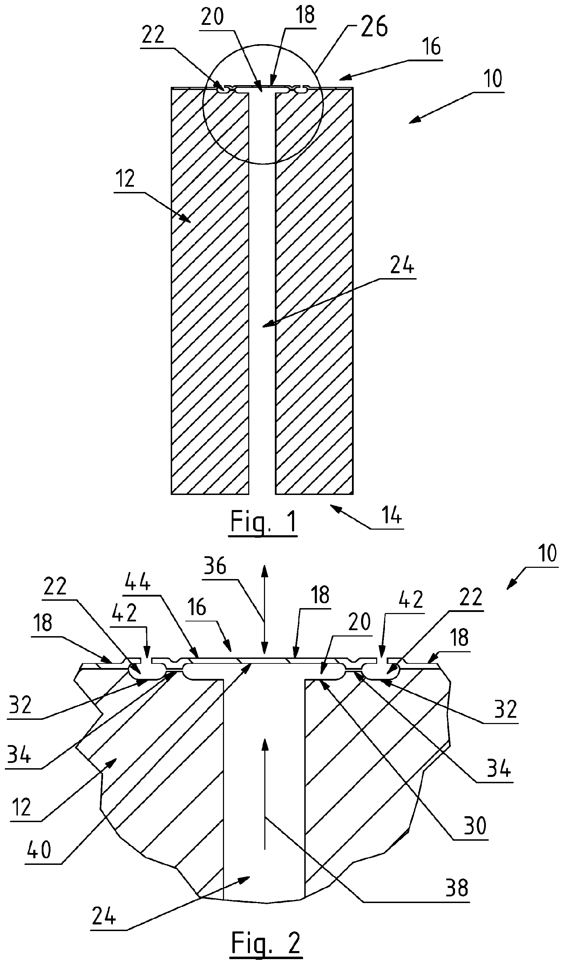

Fig. 1 zeigt ein Mikrorückschlagventil 10 gemäß einer ersten Ausführungsform in Schnittdarstellung. Hierbei ist ein Substratkörper 12 zu erkennen, der eine Unterseite 14 und eine Oberseite 16 aufweist. Auf der Oberseite 16 ist eine Schicht, zum Beispiel aus Nitrid, abgeschieden worden, die eine Membran 18 bildet. Der Substratkörper 12 weist Vertiefungen auf, sodass zwischen der Membran 18 und dem Substratkörper 12 eine erste Kammer 20 und eine zweite Kammer 22 durch die Vertiefungen zusammen mit der Membran 18 gebildet werden.

Außerdem führt ein Kanal 24 durch das Substrat 12. Der durch den Kreis dargestellte Bereich 26 ist in Fig. 2 vergrößert dargestellt. Gemäß einem hier nicht dargestellten weiteren Ausführungsbeispiel sind mehrere Kanäle 24 vorhanden.

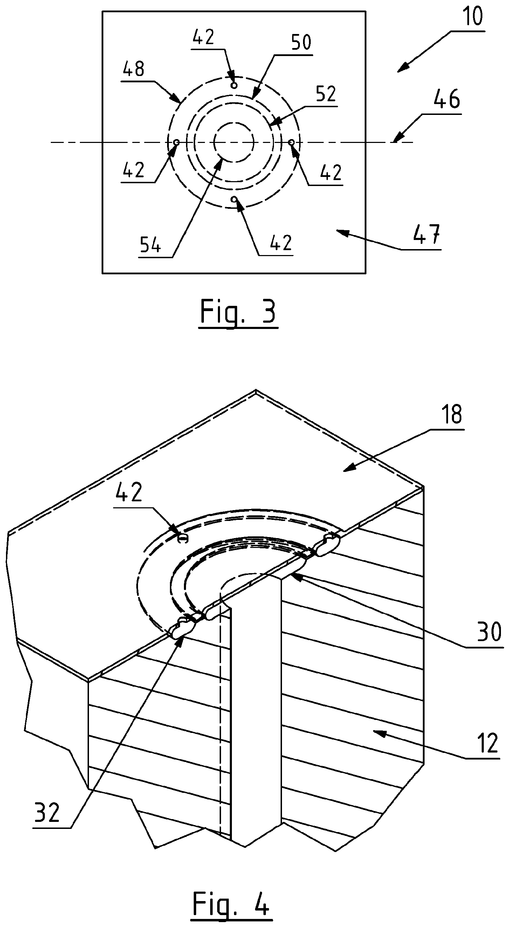

Demnach zeigt Fig. 2 den Substratkörper 12, auf dem durch Abscheidung eine Membran 18 erzeugt wurde. Der Substratkörper 12 weist eine runde Vertiefung auf, die einer ersten Wanne 30 entspricht und zusammen mit der Membran 18 die erste Kammer 20 bildet. Außerdem weist der Substratkörper eine ringförmige Vertiefung, die einer zweiten Wanne 32 entspricht, auf. Die zweite Wanne 32 ist umlaufend um die erste Wanne 30 angeordnet, dass die zweite Wanne 32 die runde Vertiefung bzw. Wanne 30 umgibt. Die zweite Wanne 32 bildet demnach mit der Membran 18 eine zweite umlaufende Kammer 22. Die runde bzw. ringförmige Ausgestaltung der Wannen 30, 32 ist durch die hier dargestellte Schnittansicht nicht erkennbar, wird jedoch in den folgenden Figuren 3 und 4 deutlich.

Zwischen der zweiten Wanne 32 und ersten Wanne 30 ist ein Dichtungssteg 34 in Form eines Stegs aus dem Substrat 12 gebildet, der nach Erzeugen der beiden Vertiefungen oder Wannen stehen bleibt. Der Kanal 24, der von der Unterseite 14, die hier gegenüber Fig. 1 nicht mehr dargestellt ist, bis zur Oberseite 16 des Substrats 12 reicht, endet in der ersten Wanne 30. Sind gemäß dem oben genannten weiteren nicht dargestellten Ausführungsbeispiel mehrere Kanäle 24 vorhanden, so reichen alle Kanäle 24 von der Unterseite 14 bis zur Oberseite 16 des Substrats 12 und enden in der ersten Wanne 30.

Im Bereich des Dichtungsstegs 34 sind die Membran 18 und der Substratkörper 12 mit einem vordefinierten Abstand, der wenige Mikro- oder Nanometer beträgt, beabstandet. Der Abstand ist jedenfalls gering im Vergleich zum Abstand der Membran 18 zum Substratkörper 12 im Bereich der Wannen 30, 32.

Die Membran 18 ist im Bereich der ersten Wanne 30 und im Bereich des Dichtungsstegs 34 flexibel und in Richtung 36, die eine Normale oder ein Normalenvektor zur Oberfläche des Substratkörpers 12 bildet, beweglich. Fließt ein Fluid oder Aerosol in Richtung 38 durch den Kanal 24 auf die Membran 18 zu, so drückt dieses von der Unterseite 40 der Membran 18 gegen die Membran 18. Der Abstand der Membran 18 zum Substratkörper 12 im Bereich des Dichtungsstegs 34 vergrößert sich, sodass ein Fluid oder Aerosol von der Kammer 20 in die Kammer 22 fließen und durch Durchbrüche 42, die im Bereich der Membran 18 oberhalb der zweiten Wanne 32 angeordnet sind, ausströmen kann.

Drückt dementgegen ein Fluid oder ein Aerosol auf die Oberseite 44 der Membran 18, so wird die Membran 18 im Bereich des Dichtungsstegs 34 gegen den Substratkörper 12 gedrückt, sodass die Verbindung zwischen den Kammern 20 und 22 verschlossen und somit ein Rückfluss oder Rückstrom verhindert oder zumindest reduziert wird.

Fig. 3 zeigt eine Draufsicht auf das Mikrorückschlagventil 10 aus den Figuren 1 und 2. Gemäß diesem Ausführungsbeispiel sind exemplarisch vier Durchbrüche 42 vorgesehen. Das in den Figuren 1 bis 3 beschriebene Ausführungsbeispiel kann jedoch auch eine andere Anzahl von Durchbrüchen gemäß weiteren Ausführungsbeispielen aufweisen. Die Linie 46 zeigt hierbei die Schnittlinie an, gemäß der der Schnitt in Fig. 1 dargestellt ist. Der Bereich der Membran 18, der über der zweiten Wanne 32 liegt, ist durch die strichlierten Linien 48 und 50 dargestellt. Der Bereich der Membran 18 oberhalb der ersten Wanne 30 ist durch die strichlierte Linie 52 dargestellt und somit wird der Bereich der Membran 18, der oberhalb dem Dichtungssteg 34 liegt, durch die strichlierten Linien 50 und 52 dargestellt.

Durch die strichlierte Linie 54 ist der Bereich der Membran 18 dargestellt, der oberhalb dem Kanal 24 liegt. Die Membran 18 ist zumindest innerhalb der strichlierten Linie 48, die als Außenkreisdurchmesser der zweiten Wanne 32 und somit als Anfangsbereich eines äußeren Wannenrandes 47 bezeichnet werden kann, in Normalenrichtung zur Bildebene bewegbar, während die Membran 18 außerhalb der strichlierten Linie 48, also im Bereich des äußeren Wannenrandes 47, fest oder unbeweglich mit dem Substratkörper 12 verbunden ist. Zusätzlich ist der Schnitt aus Fig. 1 in Fig. 4 perspektivisch dargestellt.

Fig. 4 zeigt demnach erneut den Substratkörper 12 sowie die Membran 18. Gleiche Bezugsziffern wie in den vorhergehenden Figuren 1 bis 3 entsprechen gleichen Merkmalen.

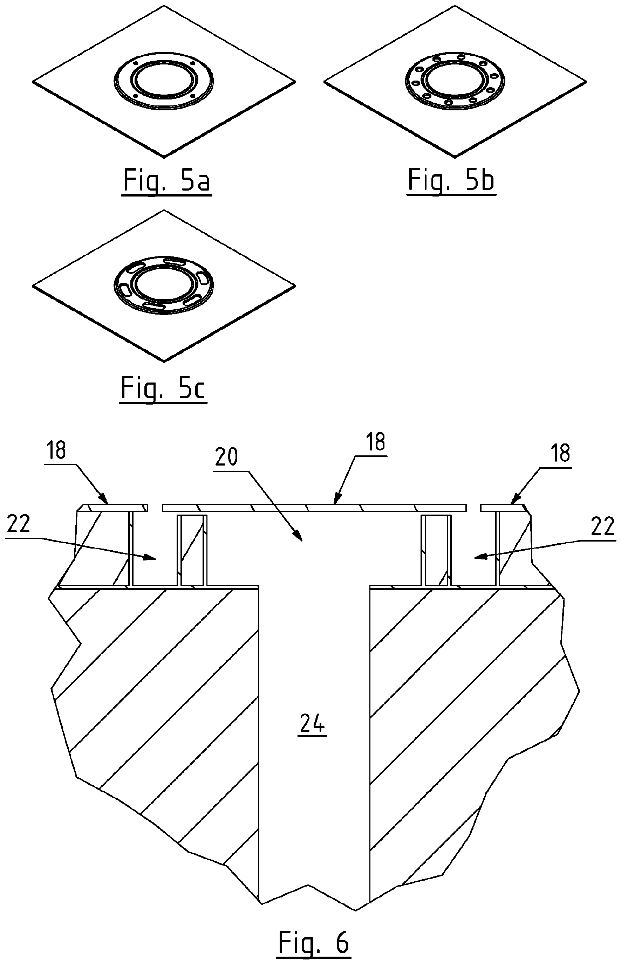

Die Figuren 5a bis 5c zeigen jeweils die Oberseite 16 eines Mikrorückschlagventils 10, wobei die verschiedenen Ausführungsbeispiele unterschiedliche Anzahlen sowie Formen der Durchbrüche 42 aufweisen.

Fig. 5a zeigt vier gleichmäßig oberhalb der zweiten Wanne 32 verteilte runde Durchbrüche 42. Fig. 5b zeigt eine Vielzahl von runden Durchbrüchen 42, die gleichmäßig auf der Membran 18 im Bereich oberhalb der zweiten Wanne 32 angeordnet sind und Fig. 5c zeigt sechs ovale Durchbrüche 42, die gleichmäßig über die Fläche des Kreisrings oberhalb der zweiten Wanne 32 angeordnet sind.

Die verschiedenen Anordnungen, Formen sowie Anzahlen der Durchbrüche 42 ermöglichen das Einstellen einer bestimmten Vorzugssprührichtung sowie der Steuerung der Durchflussmenge und einer Mindestdruckdifferenz zum Öffnen oder Schließen des Ventils. Demnach lässt sich das Mikrorückschlagventil 10 direkt auch als Sprühkopf einsetzen.

Fig. 6 zeigt eine alternative Ausgestaltung des Mikrorückschlagventils 10, das durch eine alternative Fertigungstechnik zur Fertigungstechnik des Mikrorückschlagventils 10, das in den Figuren 1 bis 4 gezeigt wurde, hergestellt ist. Gleiche Bezugsziffern entsprechen jedoch den gleichen Merkmalen wie in den Figuren 1 und 4 dargestellt.

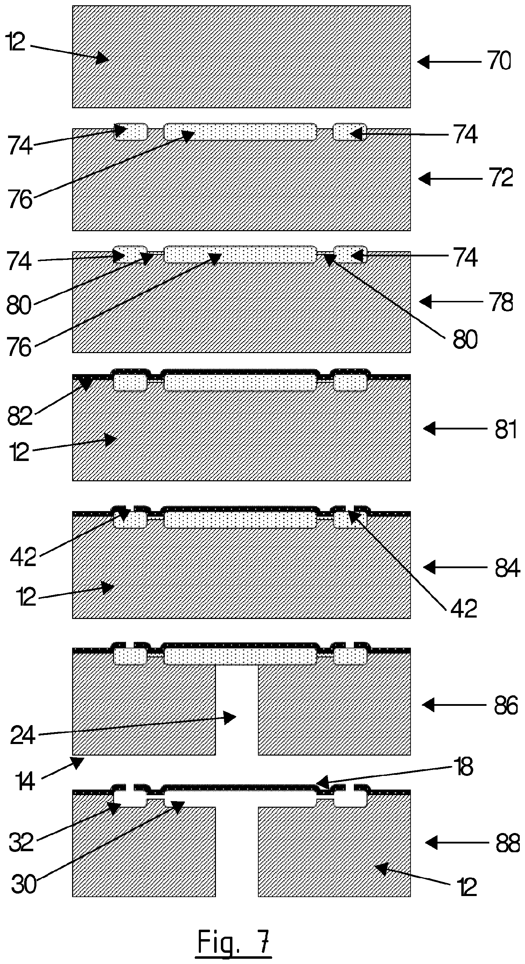

Fig. 7 zeigt die Schritte zur Herstellung eines Mikrorückschlagventils 10 gemäß einem Ausführungsbeispiel des Verfahrens. Hierbei wird im Schritt 70 ein Substratkörper 12 bereitgestellt. Im Schritt 72 werden, vorzugsweise durch einen LOCOS-Prozess (Local Oxidation of Silicon), eine erste Oxidschicht 76, die vorzugsweise rund ist, sowie eine zweite Oxidschicht 74, die vorzugsweise ringförmig ist, erzeugt. Im Schritt 78 wird eine dritte Oxidschicht 80 zwischen der zuvor erzeugten ersten Oxidschicht 76 und zweiten Oxidschicht 74 erzeugt, die vorzugsweise ringförmig ist. Die dritte Oxidschicht 80 ist vorzugsweise auch durch einen LOCOS-Prozess hergestellt ist, wobei die dritte Oxidschicht jedoch mit einer geringeren Dicke erzeugt wird. Im Schritt 81 wird dann eine Schicht 82, zum Beispiel ein Siliziumnitrid, abgeschieden, das eine Membran 18 für das spätere Rückschlagventil 10 bildet. Oberhalb der zweiten Oxidschicht 74 werden Durchbrüche 42 in die abgeschiedene Schicht 82 eingebracht und im Schritt 86 ein Kanal 24 von einer Unterseite 14 des Substrats 12 bis zur ersten Oxidschicht 76 durch das Substrat 12 geätzt. Die Oxidschichten 74, 76, 80 werden dann im Schritt 88 durch Opferschichtätzen entfernt.

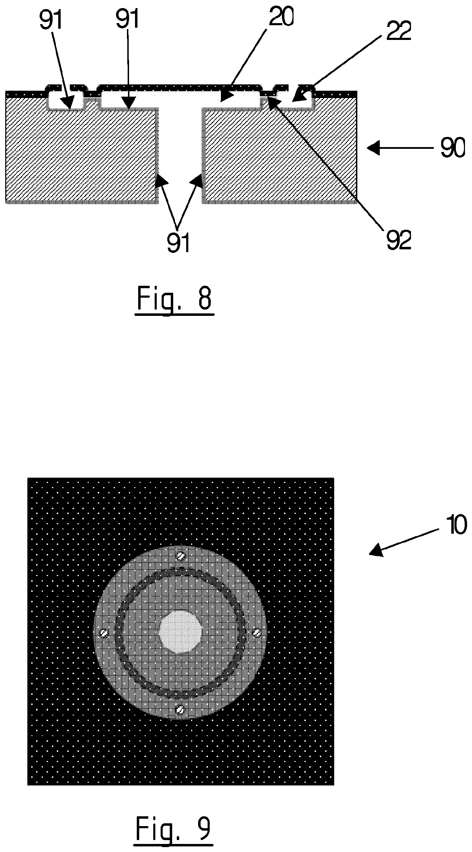

Fig. 8 zeigt einen zusätzlichen Schritt 90 zu den in Fig. 7 gezeigten Schritten, durch den gemäß einem weiteren Ausführungsbeispiel eine weitere Oxidschicht 91 über die Struktur des Mikrorückschlagventils, insbesondere im Inneren des Mikrorückschlagventils, erzeugt wird. Hierzu wird nach dem Schritt 88, bei dem die Oxidschichten entfernt werden, das Substrat erneut oxidiert. Hierdurch wird der Abstand 92 zwischen Membran und dem Dichtungssteg 34, der auch als Spalt oder Gap bezeichnet werden kann, verringert, um eine bessere Schließwirkung zu erzielen.

Fig. 9 zeigt eine Draufsicht auf das mit den in Fig. 7 dargestellten Schritten und optional mit dem in Fig. 8 beschriebenen Schritt hergestellte Mikrorückschlagventil 10.

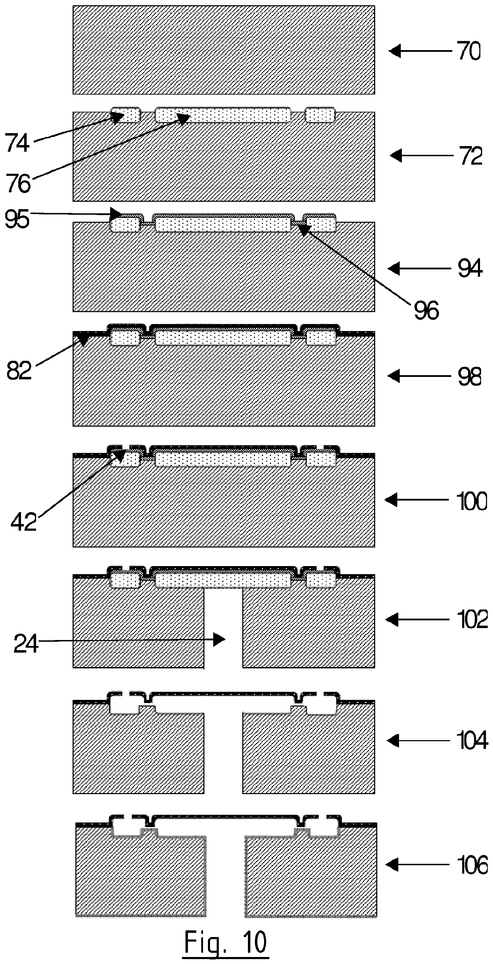

Fig. 10 zeigt ein alternatives Verfahren zum Herstellen des Mikrorückschlagventils 10. Zunächst wird wieder in einem Schritt 70 ein Substratkörper 12 bereitgestellt. Im Schritt 72 werden eine erste Oxidschicht 76, die vorzugsweise rund ist, sowie eine zweite Oxidschicht 74, die vorzugsweise ringförmig ist, erzeugt. Die erste Oxidschicht 70 und die zweite Oxidschicht 74 werden vorzugsweise durch einen LOCOS-Prozess hergestellt. Im Schritt 94 wird nun jedoch eine Oxidschicht 95 im Bereich über der ersten Oxidschicht 76, der zweiten Oxidschicht 74 sowie über dem dazwischenliegenden Bereich 96 durch einen Abscheidungsprozess, beispielsweise einen LPCVD-Prozess, abgeschieden. Darauf werden die Schritte 98, 100, 102, 104 und 106 so ausgeführt wie die Schritte 81, 84, 86, 88, 90.

Demnach wird also im Schritt 98 eine Schicht 82, zum Beispiel ein Siliziumnitrid, abgeschieden, das die Membran 18 für das spätere Rückschlagventil 10 bildet. Oberhalb der zweiten Oxidschicht 74 werden dann in einem Schritt 100 Durchbrüche 42 in die abgeschiedene Schicht 82 eingebracht und im Schritt 102 ein Kanal 24 von einer Unterseite 14 des Substrats 12 bis zur ersten Oxidschicht 76 durch das Substrat 12 geätzt. Die Oxidschichten 74, 76, 95 werden dann im Schritt 104 durch Opferschichtätzen entfernt. Hierbei wird nun zunächst die zuletzt abgeschiedene Oxidschicht 95 angegriffen, sodass der Abbau der übrigen Oxidschicht aufgrund der vergrößerten Oberfläche zum Angriff der Oxidschichten wesentlich schneller erfolgen kann. Der Schritt 104 ist somit zwar identisch zum Schritt 88, dauert aber in seiner Ausführung wesentlich weniger lange.

Schritt 106 entspricht dem in Fig. 8 gezeigten optionalen zusätzlichen Schritt zum Erzeugen einer oxidierten Oberfläche.

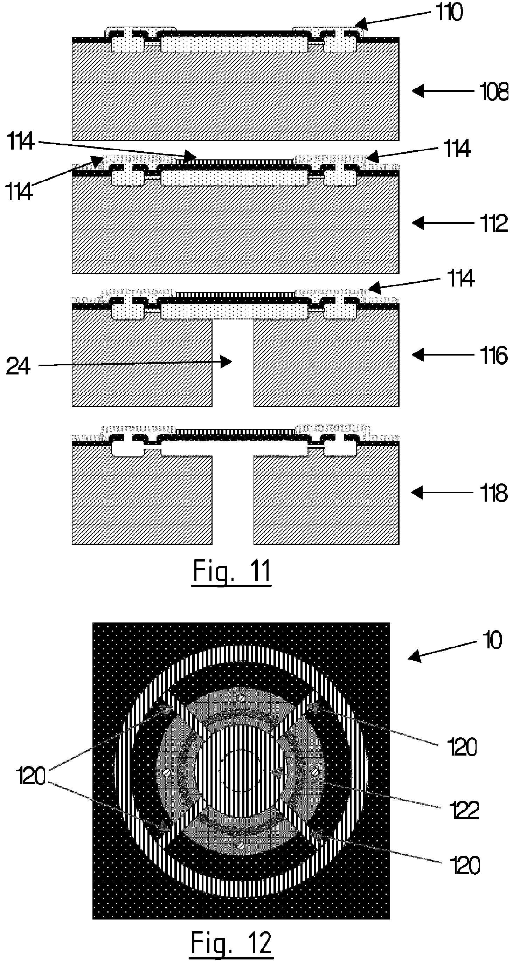

Fig. 11 zeigt abgewandelte Schritte der in Fig. 7 beschriebenen Herstellung zum Erzeugen der Federarme und des Versteifungselements. Demnach werden zunächst die Schritte 70, 72, 78, 81 und 84 wie in Fig. 7 beschrieben durchgeführt. Daraufhin wird jedoch in einem Schritt 108 eine Oxidschicht 110 zumindest in einem ringförmigen Bereich, der teilweise oberhalb dem späteren beweglichen Bereich der Membran 18 liegt, erzeugt. Im Schritt 112 wird dann eine Polysiliziumstruktur 114 erzeugt, die die Form der späteren Federarme sowie des Versteifungselements aufweist. Daraufhin wird in einem Schritt 116 der Kanal 24 geätzt und in einem Schritt 118 die Oxidschichten 74, 76, 80 und 110 entfernt.

Fig. 12 zeit das Mikrorückschlagventil, das nach den in Bezug auf Fig. 11 beschriebenen Schritten hergestellt ist in Draufsicht. Hier sind nun im Vergleich zu Fig. 9 die Federarme 120 sowie das Versteifungselement 122 dargestellt.

### Bezuqszeichenliste

- 10: Mikrorückschlagventil
- 12: Substratkörper
- 14: Unterseite des Substratkörpers
- 16: Oberseite des Substratkörpers
- 18: Membran
- 20: erste Kammer
- 22: zweite Kammer
- 24: Kanal
- 26: Bereich
- 30: erste Wanne
- 32: zweite Wanne
- 34: Dichtungssteg
- 36,38: Richtungen
- 40: Unterseite der Membran
- 42: Durchbrüche
- 44: Oberseite der Membran
- 46: Schnittlinie
- 47: äußerer Wannenrand
- 48-54: strichlierte Linien
- 70, 72, 78: Schritte des Verfahrens
- 74: zweite Oxidschicht
- 76: erste Oxidschicht
- 80: dritte Oxidschicht
- 81: Schritt des Verfahrens
- 82: abgeschiedene Schicht
- 86,88, 90: Schritte des Verfahrens
- 91: weitere Oxidschicht
- 92: Abstand, Gap oder Spalt
- 94: Schritt
- 95: Oxidschicht
- 96: Bereich
- 98-108: Schritte
- 110: Oxidschicht
- 112: Schritt
- 114: Polysiliziumstruktur
- 116, 118: Schritte
- 120: Federarme
- 122: Versteifungselement

## Patentansprüche

1. Mikrorückschlagventil mit einem Substratkörper (12) mit einer Oberseite (16) und einer Unterseite (14), wobei
die Oberseite (16) eine erste Wanne (30) und eine zweite Wanne (32) mit einem zwischen der ersten Wanne und zweiten Wanne liegenden Dichtungssteg (34) umfasst und
der Substratkörper (12) mindestens einen Kanal (24) aufweist, der von der Unterseite (14) des Substratkörpers (12) zur Oberseite (16) des Substratkörpers (12) führt und in der ersten Wanne (30) endet, **dadurch gekennzeichnet, dass** auf der Oberseite (16) des Substratkörpers (12) eine abgeschiedene Membran (18) angeordnet ist, die zumindest im Bereich oberhalb der ersten Wanne (30), der zweiten Wanne (32) und des Dichtungsstegs (34) flexibel ist, um sich zumindest in Richtung eines Normalenvektors (36) zur Oberfläche (16) des Substratkörpers (12) gegenüber dem Substratkörper zu bewegen und
die Membran (18) mindestens einen Durchbruch (42) aufweist, der im Bereich der Membran (18) angeordnet ist, der oberhalb der zweiten Wanne (32) angeordnet ist.

2. Mikrorückschlagventil nach Anspruch 1, wobei die erste Wanne (30) als erste, vorzugsweise runde, insbesondere kreisförmige, Vertiefung im Substratkörper (12) und die zweite Wanne (32) als zweite, vorzugsweise ringförmige, insbesondere kreisringförmige, die erste Vertiefung umlaufende, Vertiefung im Substratkörper (12) ausgebildet ist, und die erste Wanne (30) umlaufend durch den Dichtungssteg (34) von der zweiten Wanne (32) getrennt ist, wobei der Dichtungssteg (34) vorzugsweise ringförmig, insbesondere kreisringförmig, ist.

3. Mikrorückschlagventil nach Anspruch 1 oder 2, wobei die erste Wanne (30) mit der Membran (18) eine innere Kammer (20) und die zweite Wanne (32) mit der Membran (18) eine äußere Kammer (22) definiert und der Dichtungssteg (34) eine Dichtung bildet, die eingerichtet ist, zusammen mit der Membran (18) einen Fluidfluss und/oder Aerosolfluss zwischen der inneren Kammer (20) und der äußeren Kammer (22) im Wesentlichen zu verhindern.

4. Mikrorückschlagventil nach einem der vorhergehenden Ansprüche, wobei das Mikrorückschlagventil (10) einen geöffneten und einen geschlossenen Zustand aufweist und ausgebildet ist, den geöffneten Zustand einzunehmen, wenn eine Druckdifferenz eines Fluides oder Aerosols zwischen dem Druck im Kanal (24) und einem Druck oberhalb der Membran (18) auf oder über einer vordefinierten Mindestdruckdifferenz liegt, und den geschlossenen Zustand einzunehmen, wenn die Druckdifferenz unterhalb der Mindestdruckdifferenz liegt.

5. Mikrorückschlagventil nach einem der vorhergehenden Ansprüche, wobei der Dichtungssteg (34) an seiner Oberseite eine Ebene, nämlich eine Dichtfläche, definiert, die tiefer im Substratkörper (12) liegt als die durch die Oberseite (16) des Substratkörpers (12) gebildete Ebene, die zumindest außerhalb eines Außendurchmessers (48) der zweiten Wanne (32), vorzugsweise eines äußeren Wannenrandes (47), liegt.

6. Mikrorückschlagventil nach einem der vorhergehenden Ansprüche, wobei die Membran (18) mehrere Durchbrüche (42) aufweist, die oberhalb der zweiten Wanne (32) derart verteilt angeordnet sind, um mehrere vordefinierte Sprührichtungen und/oder eine vordefinierte Vorzugssprührichtung eines durch die Durchbrüche (42) geführten Fluides oder Aerosols zu erzeugen.

7. Mikrorückschlagventil nach einem der vorhergehenden Ansprüche, wobei mindestens einer oder alle Durchbrüche (42) rund und/oder mindestens einer oder alle Durchbrüche (42) oval und/oder mindestens einer oder alle Durchbrüche (42) trapezförmig, eckig, dreieckig, mehreckig mit abgerundeten Ecken sind.

8. Mikrorückschlagventil nach einem der vorhergehenden Ansprüche, wobei das Mikrorückschlagventil (10) mindestens einen Federarm (120) aufweist, der ein erstes Ende und ein zweites Ende aufweist, wobei das erste Ende direkt oder indirekt mit der Membran (18) im Bereich, in dem die Membran (18) beweglich ist, verbunden ist, und das zweite Ende mit dem Substratkörper (12) direkt oder indirekt verbunden ist und der Federarm (120) vorzugsweise aus oxidiertem Polysilizium hergestellt ist.

9. Mikrorückschlagventil nach Anspruch 8, wobei die Membran (18) zumindest im beweglichen Bereich der Membran (18) ein Versteifungselement (122), das aus einer zusätzlich zur Membran gebildeten Schicht gebildet ist und vorzugsweise einem Gitter, einem Ring oder einer Platte entspricht, und das erste Ende des mindestens einen Federarms (120) über das Versteifungselement (122) indirekt mit der Membran (18) verbunden ist.

10. Mikrorückschlagventil nach Anspruch 8 oder 9, wobei der mindestens eine Federarm (120) ausgebildet ist, eine Kraft auf den beweglichen Bereich der Membran (18) auszuüben, die in Richtung auf den Substratkörper (12) wirkt.

11. Mikrorückschlagventil nach einem der vorhergehenden Ansprüche, wobei die Dicke der Membran (18) und/oder die Federkraft des mindestens einen Federarms (120) und/oder der Oberfläche des beweglichen Teils der Membran (18) und/oder die Anzahl der Durchbrüche (42) in der Membran (18) derart gewählt ist, um einen vordefinierten Öffnungsdruck und/oder einen vordefinierten Schließdruck sowie eine vordefinierte Durchflussmenge bereitzustellen.

12. System mit mehreren Mikrorückschlagventilen (10) nach einem der Ansprüche 1 bis 11, wobei die Mikrorückschlagventile (10) einen gemeinsamen Substratkörper (12) aufweisen, wobei die Durchbrüche (42) insbesondere derart verteilt angeordnet sind, um vordefinierte Sprührichtungen und/oder eine vordefinierte Vorzugssprührichtung eines durch die Durchbrüche (42) geführten Fluides oder Aerosols zu erzeugen.

13. Verfahren zum Herstellen eines Mikrorückschlagventils (10) nach einem der Ansprüche 1 bis 11, umfassend die Schritte:
a) Erzeugen einer ersten Oxidschicht (76), die insbesondere rund ist, und einer zweiten Oxidschicht (74), die insbesondere ringförmig ist, auf der Oberseite (16) eines Substratkörpers (12), der eine Oberseite (16) und eine Unterseite (14) aufweist,
b) Abscheiden einer Schicht auf der Oberseite (16) des Substratkörpers (12) zum Bilden einer Membran (18) zumindest oberhalb der ersten Oxidschicht (76) und der zweiten Oxidschicht (74),
c) Ätzen von Durchbrüchen (42) in die Membran (18) im Bereich oberhalb der zweiten Oxidschicht (74),
d) Ätzen mindestens eines Kanals (24) von der Unterseite (14) des Substratkörpers (12) bis zur ersten Oxidschicht (76) und
e) Entfernen der Oxidschichten (74, 76).

14. Verfahren nach Anspruch 13, wobei vor Schritt b) eine dritte Oxidschicht (80) in dem Bereich zwischen der ersten Oxidschicht (76) und der zweiten Oxidschicht (74) erzeugt wird oder
eine Oxidschicht (95) im Bereich über der ersten Oxidschicht (76), der zweiten Oxidschicht (74) sowie im Bereich (96) zwischen der ersten Oxidschicht (76) und der zweiten Oxidschicht (74) durch einen Abscheidungsprozess abgeschieden wird.

15. Verfahren nach Anspruch 14, wobei die erzeugte dritte Oxidschicht (80) des ringförmigen Bereichs für einen Abstand (92) mit einer Dicke erzeugt wird, die geringer ist als die Dicke der ersten Oxidschicht (76) und der zweiten Oxidschicht (74) und/oder
wobei die Membran (18) mit einer Schichtdicke abgeschieden wird, die von einer vorbestimmten Mindestdruckdifferenz für das Öffnen und Schließen des Mikrorückschlagventils (10) abhängig ist und/oder
wobei nach Schritt e) eine Oxidation (90, 106) der erzeugten Struktur durchgeführt wird.

## Claims

1. A micro check valve comprising a substrate body (12) having a top side (16) and an underside (14), wherein
the top side (16) includes a first trough (30) and a second trough (32) with a sealing bar (34) between the first trough and the second trough, and
the substrate body (12) has at least one passage (24) which leads from the underside (14) of the substrate body (12) to the top side (16) of the substrate body (12) and ends in the first trough (30), **characterized in that**
arranged on the top side (16) of the substrate body (12) is a deposited diaphragm (18) which is flexible at least in the region above the first trough (30), the second trough (32) and the sealing bar (34) in order to move at least in the direction of a normal vector (36) to the surface (16) of the substrate body (12) with respect to the substrate body, and
the diaphragm (18) has at least one through opening (42) arranged in the region of the diaphragm (18), that is arranged above the second trough (32).

2. A micro check valve according to claim 1 wherein the first trough (30) is in the form of a first, preferably round, in particular circular, recess in the substrate body (12) and the second trough (32) is in the form of a second, preferably annular, in particular circular-annular, recess extending around the first recess in the substrate body (12) and the first trough (30) is separated from the second trough (32) extending around same by the sealing bar (34), wherein the sealing bar (34) is preferably annular, in particular circular-annular.

3. A micro check valve according to claim 1 or claim 2 wherein the first trough (30) with the diaphragm (18) defines an inner chamber (20) and the second trough (32) with the diaphragm (18) defines an outer chamber (22) and the sealing bar (34) forms a sealing means adapted together with the diaphragm (18) substantially to prevent a fluid flow and/or aerosol flow between the inner chamber (20) and the outer chamber (22).

4. A micro check valve according to one of the preceding claims wherein the micro check valve (10) has an opened and a closed state and is adapted to assume the opened state when a pressure difference of a fluid or aerosol between the pressure in the passage (24) and a pressure above the diaphragm (18) is at or over a predefined minimum pressure difference and to assume a closed state when the pressure difference is beneath the minimum pressure difference.

5. A micro check valve according to one of the preceding claims wherein at its top side the sealing bar (34) defines a plane, namely a sealing surface, which is deeper in the substrate body (12) than the plane which is formed by the top side (16) of the substrate body (12) and which is at least outside an outside diameter (48) of the second trough (32), preferably an outer trough edge (47).

6. A micro check valve according to one of the preceding claims wherein the diaphragm (18) has a plurality of through openings (42) arranged above the second trough (32) distributed in such a way as to produce a plurality of predefined spray directions and/or a predefined preferential spray direction of a fluid or aerosol passed through the through openings (42).

7. A micro check valve according to one of the preceding claims wherein at least one or all through openings (42) are round and/or at least one or all through openings (42) are oval and/or at least one or all through openings (42) are trapezoidal, angular, triangular, polygonal with rounded corners.

8. A micro check valve according to one of the preceding claims wherein the micro check valve (10) has at least one spring arm (120) having a first end and a second end, wherein the first end is directly or indirectly connected to the diaphragm (18) in the region in which the diaphragm (18) is moveable and the second end is directly or indirectly connected to the substrate body (12) and the spring arm (120) is preferably produced from oxidised polysilicon.

9. A micro check valve according to claim 8 wherein the diaphragm (18) at least in the moveable region of the diaphragm (18) has a stiffening element (122) which is formed from a layer formed additionally to the diaphragm and preferably corresponds to a grid, a ring or a plate and the first end of the at least one spring arm (120) is indirectly connected to the diaphragm (18) by way of the stiffening element (122).

10. A micro check valve according to claim 8 or claim 9 wherein the at least one spring arm (120) is adapted to apply a force to the moveable region of the diaphragm (18), that acts in the direction of the substrate body (12).

11. A micro check valve according to one of the preceding claims wherein the thickness of the diaphragm (18) and/or the spring force of the at least one spring arm (120) and/or the area of the moveable part of the diaphragm (18) and/or the number of through openings (42) in the diaphragm (18) is selected so as to provide a predefined opening pressure and/or a predefined closing pressure and a predefined through-flow quantity.

12. A system comprising a plurality of micro check valves (10) according to one of claims 1 to 11, wherein the micro check valves (10) have a common substrate body (12),, wherein the through openings (42) in particular are arranged distributed in such a way to produce predefined spray directions and/or a predefined preferential spray direction of a fluid or aerosol passed through the through openings (42).

13. A method for the production of a micro check valve (10) according to one of claims 1 to 11, including the steps:
a) producing a first oxide layer (76) which in particular is round and a second oxide layer (74) which in particular is annular on the top side (16) of a substrate body (12) which has a top side (16) and an underside (14),
b) depositing a layer on the top side (16) of the substrate body (12) to form a diaphragm (18) at least above the first oxide layer (76) and the second oxide layer (74),
c) etching through openings (42) in the diaphragm (18) in the region above the second oxide layer (74),
d) etching at least one passage (24) from the underside (14) of the substrate body (12) to the first oxide layer (76), and
e) removing the oxide layers (74, 76).

14. A method according to claim 13 wherein before step b) a third oxide layer (80) is produced in the region between the first oxide layer (76) and the second oxide layer (74), or
an oxide layer (95) is deposited in the region over the first oxide layer (76), the second oxide layer (74) and in the region (96) between the first oxide layer (76) and the second oxide layer (74) by a deposition process.

15. A method according to claim 14 wherein the produced third oxide layer (80) of the annular region is produced for a spacing (92) of a thickness less than the thickness of the first oxide layer (76) and the second oxide layer (74)and/or
wherein the diaphragm (18) is deposited with a layer thickness which is dependent on a predetermined minimum pressure difference for opening and closing of the micro check valve (10) and/or
wherein after step e) oxidation (90, 106) of the structure produced is carried out.

## Revendications

1. Micro-clapet antiretour avec un corps de substrat (2) avec un côté supérieur (16) et un côté inférieur (14), dans lequel
le côté supérieur (16) comporte une première cuvette (30) et une seconde cuvette (32) avec une nervure d'étanchéité (34) se trouvant entre la première cuvette et la seconde cuvette et
le corps de substrat (12) présente au moins un canal (24) qui mène du côté inférieur (14) du corps de substrat (12) au côté supérieur (16) du corps de substrat (12) et se termine dans la première cuvette (30), **caractérisé en ce que**
une membrane (18) séparée est agencée sur le côté supérieur (16) du corps de substrat (12), laquelle est flexible au moins dans la zone au-dessus de la première cuvette (30), de la seconde cuvette (32) et de la nervure d'étanchéité (34) afin de se déplacer au moins en direction d'un vecteur normal (36) à la surface (16) du corps de substrat (12) par rapport au corps de substrat et
la membrane (18) présente au moins une interruption (42) qui est agencée dans la zone de la membrane (18) qui est agencée au-dessus de la seconde cuvette (32).

2. Micro-clapet antiretour selon la revendication 1, dans lequel la première cuvette (30) est réalisée comme première cavité de préférence ronde, en particulier circulaire dans le corps de substrat (12) et la seconde cuvette (32) est réalisée comme seconde cavité de préférence annulaire, en particulier annulaire et circulaire, entourant la première cavité dans le corps de substrat (12), et la première cuvette (30) est séparée de manière périphérique par la nervure d'étanchéité (34) de la seconde cuvette (32), dans lequel la nervure d'étanchéité (34) est de préférence annulaire, en particulier annulaire et circulaire.

3. Micro-clapet antiretour selon la revendication 1 ou 2, dans lequel la première cuvette (30) définit avec la membrane (18) une chambre intérieure (20) et la seconde cuvette (32) définit avec la membrane (18) une chambre extérieure (22) et la nervure d'étanchéité (34) forme un joint d'étanchéité qui est conçu afin d'empêcher sensiblement conjointement avec la membrane (18) un flux de fluide et/ou un flux d'aérosol entre la chambre intérieure (20) et la chambre extérieure (22).

4. Micro-clapet antiretour selon l'une des revendications précédentes, dans lequel le micro-clapet antiretour (10) présente un état ouvert et un état fermé et est réalisé afin d'occuper l'état ouvert lorsqu'une différence de pression d'un fluide ou d'un aérosol entre la pression dans le canal (24) et une pression au-dessus de la membrane (18) se trouve à ou au-dessus d'une différence de pression minimale prédéfinie, et d'occuper l'état fermé lorsque la différence de pression se trouve en dessous de la différence de pression minimale.

5. Micro-clapet antiretour selon l'une des revendications précédentes, dans lequel la nervure d'étanchéité (34) définit au niveau de son côté supérieur un plan, à savoir une surface étanche, qui se situe plus profond dans le corps de substrat (12) que le plan formé par le côté supérieur (16) du corps de substrat (12) qui se trouve au moins en dehors d'un diamètre extérieur (48) de la seconde cuvette (32), de préférence d'un bord de cuvette (47) extérieur.

6. Micro-clapet antiretour selon l'une des revendications précédentes, dans lequel la membrane (18) présente plusieurs interruptions (42) qui sont agencées réparties au-dessus de la seconde cuvette (32) de manière à générer plusieurs sens de pulvérisation prédéfinis et/ou un sens de pulvérisation préféré prédéfini d'un fluide ou d'un aérosol guidé à travers les interruptions (42).

7. Micro-clapet antiretour selon l'une des revendications précédentes, dans lequel au moins une ou toutes les interruptions (42) sont rondes et/ou au moins une ou toutes les interruptions (42) sont ovales et/ou au moins une ou toutes les interruptions (42) sont en forme de trapèze, carré, triangle, polygone avec des coins arrondis.

8. Micro-clapet antiretour selon l'une des revendications précédentes, dans lequel le micro-clapet antiretour (10) présente au moins un bras de ressort (120) qui présente une première extrémité et une seconde extrémité, dans lequel la première extrémité est reliée directement ou indirectement à la membrane (18) dans la zone dans laquelle la membrane (18) est mobile, et la seconde extrémité est reliée au corps de substrat (12) directement ou indirectement et le bras de ressort (120) est fabriqué de préférence en polysilicium oxydé.

9. Micro-clapet antiretour selon la revendication 8, dans lequel la membrane (18) est au moins dans la zone mobile de la membrane (18) un élément de renforcement (122) qui est formé à partir d'une couche formée outre la membrane et correspond de préférence à une grille, un anneau ou une plaque, et la première extrémité d'au moins un bras de ressort (120) est reliée par le biais de l'élément de renforcement (122) indirectement à la membrane (18).

10. Micro-clapet antiretour selon la revendication 8 ou 9, dans lequel l'au moins un bras de ressort (120) est réalisé afin d'exercer une force sur la zone mobile de la membrane (18) qui agit en direction du corps de substrat (12).

11. Micro-clapet antiretour selon l'une des revendications précédentes, dans lequel l'épaisseur de la membrane (18) et/ou la force de ressort de l'au moins un bras de ressort (120) et/ou la surface de la partie mobile de la membrane (18) et/ou le nombre des interruptions (42) dans la membrane (18) est choisi de manière à fournir une pression d'ouverture prédéfinie et/ou une pression de fermeture prédéfinie ainsi qu'une quantité de débit prédéfinie.

12. Système avec plusieurs micro-clapets antiretour (10) selon l'une des revendications 1 à 11, dans lequel les micro-clapets antiretour (10) présentent un corps de substrat (12) commun, dans lequel les interruptions (42) sont agencées réparties en particulier de manière à générer des sens de pulvérisation prédéfinis et/ou un sens de pulvérisation préféré prédéfini d'un fluide ou d'un aérosol guidé par les interruptions (42).

13. Procédé de fabrication d'un micro-clapet antiretour (10) selon l'une des revendications 1 à 11, comprenant les étapes suivantes :
a) la génération d'une première couche d'oxyde (76) qui est en particulier ronde, et d'une deuxième couche d'oxyde (74) qui est en particulier annulaire, sur le côté supérieur (16) d'un corps de substrat (12) qui présente un côté supérieur (16) et un côté inférieur (14),
b) la séparation d'une couche sur le côté supérieur (16) du corps de substrat (12) pour la formation d'une membrane (18) au moins au-dessus de la première couche d'oxyde (76) et de la deuxième couche d'oxyde (74),
c) la gravure d'interruptions (42) dans la membrane (18) dans la zone au-dessus de la deuxième couche d'oxyde (74),
d) la gravure d'au moins un canal (24) du côté inférieur (14) du corps de substrat (12) jusqu'à la première couche d'oxyde (76) et
e) le retrait des couches d'oxyde (74, 76).

14. Procédé selon la revendication 13, dans lequel avant l'étape b), une troisième couche d'oxyde (80) est générée dans la zone entre la première couche d'oxyde (76) et la deuxième couche d'oxyde (74) ou
une couche d'oxyde (95) dans la zone sur la première couche d'oxyde (76), la deuxième couche d'oxyde (74) ainsi que dans la zone (96) entre la première couche d'oxyde (76) et la deuxième couche d'oxyde (74) est séparée par un processus de séparation.

15. Procédé selon la revendication 14, dans lequel la troisième couche d'oxyde (80) générée de la zone annulaire pour une distance (92) est générée avec une épaisseur qui est moindre que l'épaisseur de la première couche d'oxyde (76) et de la deuxième couche d'oxyde (74) et/ou
dans lequel la membrane (18) est séparée avec une épaisseur de couche qui dépend d'une différence de pression minimale prédéterminée pour l'ouverture et la fermeture du micro-clapet antiretour (10) et/ou
dans lequel après l'étape e) une oxydation (90, 106) de la structure générée est réalisée.
